# EUROPÄISCHE PATENTSCHRIFT

(11) **EP 1 031 041 B1**
(45) Veröffentlichungstag und Bekanntmachung des Hinweises auf die Patenterteilung: **26.06.2002**
(21) Anmeldenummer: 98959774.5
(22) Anmeldetag: 29.10.1998
(51) Int. Cl.: G01R 31/28

(54) **VORRICHTUNG ZUR ÜBERPRÜFUNG EINES ELEKTRISCHEN ANTRIEBS**
DEVICE FOR CHECKING AN ELECTRIC DRIVE
DISPOSITIF PERMETTANT DE CONTROLER UN MOTEUR ELECTRIQUE

(30) Priorität: 11.11.1997 DE 19749842
(43) Veröffentlichungstag der Anmeldung: 30.08.2000
(73) Patentinhaber: Framatome ANP GmbH, 91050 Erlangen (DE)
(72) Erfinder: BENKE, Harald-Peter, D-63796 Kahl (DE); HORBACH, Robert, D-63755 Alzenau (DE); KUTZER, Heinz, D-63477 Maintal (DE)
(74) Vertreter: Mörtel & Höfner
(86) Internationale Anmeldenummer: DE9803170
(87) Internationale Veröffentlichungsnummer: WO9924840

(56) Entgegenhaltungen:
- WO-A-93/08482
- DE-A- 3 936 988
- DE-C- 4 412 982
- DE-C- 19 632 457
- "POWER MANAGEMENT SLEEP-MODE CONTROL FOR MICROPROCESSORS" IBM TECHNICAL DISCLOSURE BULLETIN, Bd. 36, Nr. 8, 1. August 1993, Seiten 189-190, XP000390190

## Beschreibung

Die Erfindung betrifft eine Vorrichtung zur Überprüfung eines elektrischen Antriebs und/oder einer dem Antrieb zugeordneten mechanischen Einrichtung, die insbesondere eine Armatur oder ein Stellglied ist, wobei dem Antrieb und/oder der mechanischen Einrichtung eine Baueinheit, die Anschlüsse aufweist, zugeordnet ist, und wobei an die Anschlüsse ein Diagnosemodul anschließbar ist.

Eine Vorrichtung zur Überprüfung eines elektrischen Antriebs bzw. einer mit ihm verbundenen mechanischen Einrichtung, die eine Armatur oder ein Stellglied sein kann, ist notwendig, um den Funktionszustand des Antriebs und/oder des Stellgliedes überwachen zu können. Durch eine ständige Überwachung können rechtzeitig Störungen oder Veränderungen im Betriebsverhalten des Antriebs und/oder der mechanischen Einrichtung erkannt werden. Falls die mechanische Einrichtung eine Armatur oder ein Stellglied, die z.B. Teil eines Kraftwerkes sein können, ist, kann man Veränderungen und/oder Schäden, die die Zuverlässigkeit der Armatur oder des Stellgliedes noch nicht beeinträchtigen, aber einen sicherheitsrelevanten Schaden oder Funktionsstörungen nach sich ziehen können, frühzeitig erkennen. Ein schadhafter oder funktionsgestörter Antrieb und/oder eine schadhafte oder funktionsgestörte mechanische Einrichtung kann folglich frühzeitig erkannt und dann gewartet, repariert oder ersetzt werden. Das gleiche gilt für den Fall, daß der elektrische Antrieb einem Stellglied in einem Gleissystem zugeordnet ist, wobei es sich insbesondere um den Stellantrieb einer Eisenbahnweiche handeln kann.

Aus der EP 0 609 261 B1 ist eine Einrichtung zur Überprüfung eines elektrischen Antriebs, der insbesondere ein Antrieb einer Armatur ist, bekannt. Dabei ist dem Antrieb eine Baueinheit zugeordnet, in der von Versorgungsleitungen des Antriebs Spannungsmeßleitungen ausgehen, die an Spannungsabgriffen an der Baueinheit enden. Außerdem sind in der Baueinheit den Versorgungsleitungen Stromwandler zugeordnet, die über Strommeßleitungen mit Stromabgriffen an der Baueinheit verbunden sind. Die Stromwandler sind in der Regel den Versorgungsleitungen ohne Unterbrechung dieser Versorgungsleitungen, z.B. induktiv, zugeordnet. An die Anschlüsse der Baueinheit ist ein Diagnosemodul anschließbar. Dieses Diagnosemodul ist beim Bekannten ein Diagnosestecker, der mit einer zentralen Meßund Auswerteeinheit verbunden ist. Der Diagnosestecker nimmt an den Anschlüssen anstehende Signale auf und leitet sie über eine Leitung der Meß- und Auswerteeinheit zu.

Aus der DE 39 36 988 C2 ist ein als Stecker ausgebildetes Diagnosemodul bekannt, das eine signalverarbeitende Anordnung enthält. Diese Anordnung muß, da die Überwachung eines Antriebs lückenlos sein muß, ständig an einer Versorgungsspannungsquelle angeschlossen sein. Da im Bereich eines zu überwachenden Antriebs keine geeignete Hilfsenergie zur Verfügung steht, muß das Diagnosemodul entweder über eine aufwendige Leitung von außen versorgt oder mit einer relativ großen Bat terie versehen werden. Daher war es bisher nicht wirtschaftlich, ein Diagnosemodul ohne ständige Verbindung mit einer zentral aufgestellten Meß- und Auswerteeinheit zu konstruieren.

Der Erfindung liegt die Aufgabe zugrunde, eine Vorrichtung zur Überprüfung eines elektrischen Antriebes oder Stellgliedes und/oder einer dem Antrieb zugeordneten mechanischen Einrichtung anzugeben, wobei die Vorrichtung ein Diagnosemodul umfaßt, das einerseits während der Überprüfung nicht mit einer zentralen Auswerteeinheit verbunden sein muß und darüber hinaus nur eine relativ kleine Versorgungsleistung bzw. eine relativ kleine Einrichtung zur Energieversorgung benötigt.

Die Aufgabe wird gemäß der Erfindung dadurch gelöst, daß eine Energieversorgungseinrichtung für das Diagnosemodul vorhanden ist, die über mindestens einen der Anschlüsse an der Baueinheit oder über ein externes Signal aktivierbar ist.

Damit wird der Vorteil erzielt, daß das Diagnosemodul über zwei Betriebsmodi verfügt. Solange keine zu verarbeitenden Signale vorliegen, befindet sich das Modul in einem energiesparenden Schlafmodus. Liegen ein oder mehrere Signale an, geht das Modul in den Arbeitsmodus über. Man kommt folglich vorteilhafterweise im Diagnosemodul mit wenig Energie aus, auch dann, wenn keine zentrale Meß- und Auswerteeinheit für ein oder mehrere Diagnosmodule vorgesehen ist. Für den Eigenbedarf des Diagnosemoduls reicht eine kleiner elektischer Energiespeicher, z.B. eine Batterie, oder eine kleine Versorgungsleitung mit kleinem Querschnitt aus.

Dadurch wird insbesondere der Vorteil erzielt, daß das Diagnosemodul an Baueinheiten verschiedener Antriebe zeitlich und örtlich nacheinander eingesetzt werden kann, ohne daß hindernde Leitungsverbindungen, insbesondere Datenleitungen, vom Diagnosemodul ausgehen müßten. Die Überprüfung elektrischer Antriebe an verschiedenen Orten ist dadurch schnell und einfach möglich.

Dem Diagnosemodul ist als Energieversorgungseinrichtung beispielsweise ein elektrischer Energiespeicher und/oder eine Spannungsquelle zugeordnet, von denen zum Diagnosemodul eine Versorgungsleitung führt. Der elektrische Energiespeicher kann wieder aufladbar oder nicht wieder aufladbar sein. Er kann auch eine elektrische Kapazität sein. Infolge des Schlafmodus reicht eine derartige Energieversorgung für den Eigenbedarf des Diagnosemoduls aus.

Die Energieversorgungseinrichtung ist beispielsweise über ein an mindestens einem Anschluß der Baueinheit anliegendes Signal der Betriebsspannung und/oder des Betriebsstromes und/oder der Steuerspannung und/oder durch ein anderes Signal einschaltbar. Erst, wenn z.B. die Betriebsspannung und/oder die Steuerspannung am Antrieb anliegt, wird also das Diagnosemodul aktiviert. Solange der Antrieb in Ruhe ist, ist auch das Diagnosemodul im Schlafmodus. Da der elektrische Antrieb, der z.B. einer mechanischen Einrichtung zugeordnet ist, nur eingeschaltet wird, wenn die mechanische Einrichtung bewegt werden soll, bleibt das Diagnosemodul vorteilhafterweise sehr lange im Schlafmodus.

Beispielsweise kann ein in der Versorgungsleitung des Diagnosemoduls angeordneter Schalter über ein am Anschluß anliegendes Signal der Betriebsspannung, des Betriebsstromes und/oder der Steuerspannung des Antriebs und/oder durch ein anderes Signal schaltbar sein. Dadurch wird das Diagnosemodul in den Arbeitsmodus versetzt.

Mit einer Versorgungsleitung, die durch einen Schalter unterbrochen werden kann, kommt man mit wenig Energie für die Eigenversorgung des Diagnosemoduls aus, da dieses während sich der Antrieb im stationären Zustand befindet, den Schlafmodus einnimmt.

Das Diagnosemodul enthält beispielsweise eine Auswerteeinheit (Prozessor). Damit wird der Vorteil erzielt, daß die eingelesenen Daten des Antriebs direkt im Diagnosemodul gespeichert und/oder ausgewertet werden und/oder ein oder mehrere neue Signale generiert werden können. Eine Leitungsverbindung zu einer zentralen Auswerteeinheit ist dann nicht erforderlich oder man kommt mit einer leistungsschwachen Leitung aus, weil ein großer Teil der Auswertungen bereits im Diagnosemodul vorgenommen wird. Die Energieversorgung einer solchen Auswerteeinheit im Diagnosemodul ist mit einer kleinen Einrichtung, z.B. Batterie, oder einer kleinen Versorgungsleitung gewährleistet, weil das Diagnosemodul, während der Antrieb im stationären Zustand ist, vorteilhafterweise im Schlafmodus gehalten wird.

Das Diagnosemodul ist beispielsweise kalibrierfähig und weist dazu einen Kalibriereingang und/oder einen Kalibrierausgang auf, die z.B. mit der Auswerteeinheit verbunden sind. An beliebigen Signaleingängen, z.B. am Kalibriereingang, können bekannte Werte eingespeist werden, wonach am Kalibrierausgang Istwerte ausgegeben werden.

Mittels dieser Istwerte und der bekannten Werte wird die Übertragungsfunktion (Kalibrierkurve) des Diagnosemoduls, insbesondere der Auswerteeinheit, in der Regel außerhalb des Diagnosemoduls ermittelt. Diese Übertragungsfunktion wird im Diagnosemodul, z.B. in der Auswerteeinheit gespeichert, nachdem sie, z.B. über den Kalibriereingang, eingegeben wurde. Dadurch kann man zur Beurteilung des Antriebs oder der mechanischen Einrichtung auf geeignete Werte schließen.

Im Diagnosemodul kann ein Datenspeicher vorhanden sein, der z.B. mit der Auswerteeinheit verbunden ist. Dort können gemessene oder berechnete Daten gespeichert werden, bis das Diagnosemodul zu einem späteren Zeitpunkt zum Auslesen und weiteren Bearbeiten der Daten an eine externe Auswerteeinheit angeschlossen wird.

Mit der Auswerteeinheit im Diagnosemodul kann ein Sollwertspeicher verbunden sein, der Sollwerte enthält. Wenn in der Auswerteeinheit festgestellt wird, daß gemessene oder berechnete Werte einen Sollwert überschreiten oder unterschreiten, kann ein den Antrieb oder die zugeordnete mechanische Einrichtung kennzeichnendes Signal abgegeben werden.

Mit der Auswerteeinheit und/oder mit dem Datenspeicher können eine oder mehrere Meldevorrichtungen, z.B. Leuchtdioden, verbunden sein, mit denen angezeigt wird, daß Daten vorhanden oder gespeichert sind.

Das Diagnosemodul hat beispielsweise die Form eines Steckers und die Anschlüsse an der Baueinheit sind Abgriffe zur Aufnahme des Steckers. Damit wird der Vorteil erzielt, daß das Diagnosemodul in einfacher und schneller Weise von einer Baueinheit zu einer anderen umgesteckt werden kann, so daß in kurzer Zeit mehrere Antriebe und/oder zugeordnete mechanische Einrichtungen überprüft werden können.

Das Diagnosemodul kann nach einem anderen Beispiel eine Steckplatine sein, die ebenfalls leicht von einer Baueinheit zu einer anderen umgesteckt werden kann.

Schließlich kann das Diagnosemodul aber auch fest montierbar sein, wobei es notwendig ist, jeder Baueinheit ein solches Diagnosemodul zuzuordnen.

Das Diagnosemodul kann nach einem anderen Beispiel ein mobiles Modul sein, das leicht umsteckbar ist und durch geeignete Vorrichtungen mehreren Antrieben oder mechanischen Einrichtungen, z.B. im gemeinsamen Strang der Energieversorgung, zugeordnet sein kann.

Beispielsweise enthält das Diagnosemodul eine Lesevorrichtung, die mit einem an einen Codierungsanschluß der Baueinheit anschließbaren Codiereingang verbunden ist. Am Codierungsanschluß der Baueinheit steht eine Codierungsinformation an, die den zu überprüfenden Antrieb bzw. die mechanische Einrichtung kennzeichnet. Es wird der Vorteil erzielt, daß bei einer Überprüfung eines elektrischen Antriebes bzw. einer mechanischen Einrichtung, sofort automatisch erkannt wird, an welchem von vielen Antrieben bzw. mechanischen Einrichtungen in einer Anlage das Diagnosemodul angeschlossen ist.

Mit der Vorrichtung zur Überprüfung eines elektrischen Antriebs bzw. einer zugeordneten mechanischen Einrichtung nach der Erfindung wird insbesondere der Vorteil erzielt, daß ein Diagnosemodul mit so wenig Energie auskommt, daß insbesondere eine Auswerteeinheit und/oder auch ein Speicher im Diagnosemodul untergebracht und energetisch versorgt werden können, und daß das Diagnosemodul trotzdem so leicht und kompakt ist, daß es nacheinander an verschiedenen Baueinheiten eingesetzt werden kann.

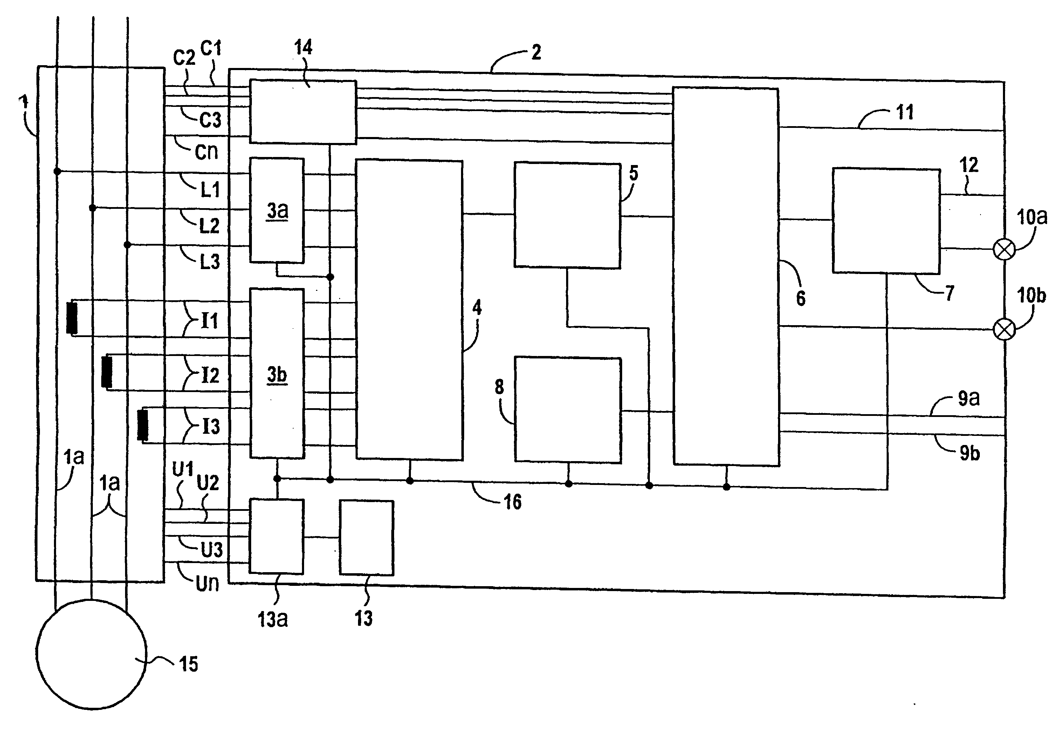

Eine Vorrichtung nach der Erfindung zur Überprüfung eines elektrischen Antriebs und/oder einer zugeordneten mechanischen Einrichtung wird anhand der Zeichnung näher erläutert. Dort ist eine solche Vorrichtung schematisch dargestellt.

Die Zeichnung zeigt eine Baueinheit 1 mit Anschlüssen C1 bis Cn für Codiersignale, Anschlüssen L1 bis L3 für Spannungssignale, Anschlüssen I1 bis I3 für Stromsignale und Anschlüssen U1 bis Un für die Betriebs- oder Steuerspannung eines zu überprüfenden Antriebs 15. Die Spannungssignale gehen in der Baueinheit 1 direkt von Versorgungsleitungen 1a des Antriebs 15 aus. Die Anschlüsse I1 bis I3 für Stromsignale sind in der Baueinheit 1 den Versorgungsleitungen 1a, z.B. induktiv, zugeordnet. Der Antrieb 15 treibt eine mechanische Einrichtung an, die eine Armatur oder ein Stellglied sein kann.

Mit der Baueinheit 1 ist ein Diagnosemodul 2 verbunden, das als Stecker ausgebildet sein kann. Dazu sind die Anschlüsse C,U,L,I an der Baueinheit 1 z.B. als Abgriffe zur Aufnahme von Kontakten des Steckers ausgebildet. Das Diagnosemodul 2 kann aber auch fest montiert oder separat montiert sein. Im Diagnosemodul 2 stehen die Anschlüsse L1 bis L3 für Spannungssignale über ein Modul 3a zur galvanischen Trennung mit einem Signalkonditionierer 4 in Verbindung. Die Anschlüsse I1 bis I3 für Stromsignale stehen direkt und/oder über das gleiche oder ein anderes Modul 3b zur galvanischen Trennung mit dem Signalkonditionierer 4 in Verbindung. Dieser steht ausgangsseitig über einen Analog-Digital-Wandler 5 mit einer Auswerteeinheit 6 in Verbindung.

Mit der Auswerteeinheit 6 stehen auch die Anschlüsse C1 bis Cn für Codiersignale über eine Lesevorrichtung 14 in Verbindung. Zum Speichern von in der Auswerteeinheit 6 bearbeiteten Daten ist diese ausgangsseitig mit einem Datenspeicher 7 verbunden.

Eingangsseitig kann die Auswerteeinheit 6 mit einem Sollwertspeicher 8 verbunden sein, um berechnete Werte mit einem Sollwert vergleichen zu können. Die Auswerteeinheit 6 ist darüber hinaus mit einem Kalibriereingang 9a und mit einem Kalibrierausgang 9b verbunden. Durch das Einspeisen von bekannten Werten am Kalibriereingang 9a oder einem anderen Eingang, z.B. vom Sollwertspeicher 8 her, erhält man am Kalibrierausgang 9b Istwerte und daraus eine Kalibrierkurve. Diese oder auch eine bekannte Kalibrierkurve können von außen am Kalibriereingang 9a in die Auswerteeinheit 6 eingespeist werden. Mit der Auswerteeinheit 6 und/oder mit dem Datenspeicher 7 können Meldevorrichtungen 10a, 10b, z.B. Leuchtdioden, verbunden sein, die anzeigen, ob Daten vorhanden sind. Meldevorrichtungen 10a, 10b können auch für andere Zwecke eingesetzt werden. Von der Auswerteeinheit 6 oder vom Speicher 7 können Datenausgabeleitungen 11, 12 mit Anschlüssen ausgehen, über die Daten an eine nicht dargestellte zentrale Auswerteeinheit abgegeben werden können.

Zur Energieversorgung des Diagnosemoduls 2 selbst enthält dieses beispielsweise einen elektrischen Energiespeicher 13, von dem ein System aus Versorgungsleitungen 16 ausgeht, das Bauteile (Energieverbraucher) des Diagnosemoduls 2 versorgt. Die Versorgungsleitungen 16 können auch von einer externen Spannungsquelle in das Diagnosemodul 2 hereingeführt sein.

Die Betriebsspannung und/oder die Steuerspannung des Antriebs 15, die an den Anschlüssen U1 bis Un an der Baueinheit 1 anstehen, sind mit einem Schalter 13a in der Versorgungsleitung 16 verbunden, die vom Energiespeicher 13 oder von der nicht dargestellten Spannungsquelle ausgeht.

Verläßt der Antrieb 15 den stationären Zustand, dann werden durch die daraus folgende Änderung der Spannungssignale und/oder der Stromsignale und/oder der Betriebs- oder Steuerspannung der elektrische Energiespeicher 13 oder die externe Spannungsquelle mit den Energieverbrauchern im Diagnosemodul 2 verbunden. Solange weder der stationäre Zustand noch eine Betriebs- oder Steuerspannung verändert werden, befinden sich also die Energieverbraucher des Diagnosemoduls 2 im Schlafmodus, so daß man mit einem kleinen Energiespeicher 13 und/oder mit einer kleinen Spannungsquelle sowie mit kleinen Versorgungsleitungen 16 auskommt. Erst dadurch ist ein handlicher Aufbau des Diagnosemoduls 2 mit integrierter Auswerteeinheit 6 möglich, so daß es leicht nacheinander an verschiedenen Baueinheiten 1 eingesetzt werden kann.

## Patentansprüche

1. Vorrichtung zur Überprüfung eines elektrischen Antriebes (15) und/oder einer dem Antrieb (15) zugeordneten mechanischen Einrichtung, die insbesondere eine Armatur oder ein Stellglied ist, wobei dem Antrieb (15) und/oder der mechanischen Einrichtung eine Baueinheit (1), die Anschlüsse (C, U, L, I) aufweist, zugeordnet ist, und wobei an die Anschlüsse (C, U, L, I) ein Diagnosemodul (2) anschließbar ist,
**dadurch gekennzeichnet, daß** eine Energieversorgungseinrichtung für das Diagnosemodul (2) vorhanden ist, die über mindestens einen der Anschlüsse (U1 bis Un) an der Baueinheit (1) oder über ein externes Signal aktivierbar ist.

2. Vorrichtung nach Anspruch 1,
**dadurch gekennzeichnet, daß** die Energieversorgungseinrichtung ein dem Diagnosemodul (2) zugeordneter elektrischer Energiespeicher (13) und/oder eine Spannungsquelle ist, von denen zum Diagnosemodul (2) eine Versorgungsleitung (16) führt.

3. Vorrichtung nach einem der Ansprüche 1 oder 2,
**dadurch gekennzeichnet, daß** die Energieversorgungseinrichtung über ein an mindestens einem Anschluß (U1 bis Un) anliegendes Signal der Betriebsspannung und/oder des Betriebsstromes und/oder der Steuerspannung des Antriebes (15) einschaltbar ist.

4. Vorrichtung nach Anspruch 2,
**dadurch gekennzeichnet, daß** ein in der Versorgungsleitung (16) angeordneter Schalter (13a) über ein an mindestens einem Anschluß (U1 bis Un) anliegendes Signal der Betriebsspannung und/oder des Betriebsstromes und/oder der Steuerspannung des Antriebs (15) schaltbar ist.

5. Vorrichtung nach einem der Ansprüche 1 bis 4,
**dadurch gekennzeichnet, daß** das Diagnosemodul (2) eine Auswerteeinheit (6) enthält.

6. Vorrichtung nach Anspruch 5,
**dadurch gekennzeichnet, daß** die Auswerteeinheit (6) mit einem Kalibriereingang (9a) des Diagnosemoduls (2) und/oder mit einem Kalibrierausgang (9b) des Diagnosemoduls (2) verbunden ist.

7. Vorrichtung nach einem der Ansprüche 1 bis 6,
**dadurch gekennzeichnet, daß** im Diagnosemodul (2) ein Datenspeicher (7) vorhanden ist.

8. Vorrichtung nach einem der Ansprüche 5 bis7,
**dadurch gekennzeichnet, daß** mit der Auswerteeinheit (6) ein Sollwertspeicher (8) verbunden ist.

9. Vorrichtung nach einem der Ansprüche 5 bis 8,
**dadurch gekennzeichnet, daß** mit der Auswerteeinheit (6) eine Meldevorrichtung (10b) verbunden ist.

10. Vorrichtung nach einem der Ansprüche 1 bis 9,
**dadurch gekennzeichnet, daß** das Diagnosemodul (2) die Form eines Steckers hat und die Anschlüsse (C, U, L, I) an der Baueinheit (1) Abgriffe zur Aufnahme des Steckers sind.

11. Vorrichtung nach einem der Ansprüche 1 bis 9,
**dadurch gekennzeichnet, daß** das Diagnosemodul (2) eine Steckplatine ist.

12. Vorrichtung nach einem der Ansprüche 1 bis 9,
**dadurch gekennzeichnet, daß** das Diagnosemodul (2) fest montierbar ist.

13. Vorrichtung nach einem der Ansprüche 1 bis 9,
**dadurch gekennzeichnet, daß** das Diagnosemodul (2) ein mobiles Modul ist.

14. Vorrichtung nach einem der Ansprüche 1 bis 13,
**dadurch gekennzeichnet, daß** das Diagnosemodul (2) eine Lesevorrichtung (14) enthält, die mit einem an einem Codierungsanschluß (C) der Baueinheit (1) anschließbaren Codiereingang verbunden ist.

## Claims

1. Apparatus for checking an electrical drive (15) and/or a mechanical device which is associated with the drive (15) and is, in particular, an accessory or an actuating element, in which case the drive (15) and/or the mechanical device have/has an associated unit (1) which has connections (C, U, L, I), and in which case a diagnosis module (2) can be connected to the connections (C, U, L, I),
**characterized in that** a power supply device is provided for the diagnosis module (2) and can be activated via at least one of the connections (U1 to Un) to the unit (1) or via an external signal.

2. Apparatus according to Claim 1,
**characterized in that** the power supply device is an electrical energy store (13) associated with the diagnosis module (2) and/or is a voltage source, from which devices a supply line (16) leads to the diagnosis module (2).

3. Apparatus according to one of Claims 1 or 2,
**characterized in that** the power supply device can be switched on via a signal, which is applied to at least one connection (U1 to Un), of the operating voltage and/or of the operating current and/or of the control voltage of the drive (15).

4. Apparatus according to Claim 2,
**characterized in that** a switch (13a) which is arranged in the supply line (16) can be switched via a signal, which is applied to at least one connection (U1 to Un), of the operating voltage and/or of the operating current and/or of the control voltage of the drive (15).

5. Apparatus according to one of Claims 1 to 4,
**characterized in that** the diagnosis module (2) contains an evaluation unit (6).

6. Apparatus according to Claim 5,
**characterized in that** the evaluation unit (6) is connected to a calibration input (9a) of the diagnosis module (2), and/or to a calibration output (9b) of the diagnosis module (2).

7. Apparatus according to one of Claims 1 to 6,
**characterized in that** a data store (7) is provided in the diagnosis module (2).

8. Apparatus according to one of Claims 5 to 7,
**characterized in that** a required value store (8) is connected to the evaluation unit (6).

9. Apparatus according to one of Claims 5 to 8,
**characterized in that** a signalling apparatus (10b) is connected to the evaluation unit (6).

10. Apparatus according to one of Claims 1 to 9,
**characterized in that** the diagnosis module (2) is in the form of a plug, and the connections (C, U, L, I) to the unit (1) are taps for holding the plug.

11. Apparatus according to one of Claims 1 to 9,
**characterized in that** the diagnosis module (2) is a plug-in board.

12. Apparatus according to one of Claims 1 to 9,
**characterized in that** the diagnosis module (2) can be installed permanently.

13. Apparatus according to one of Claims 1 to 9,
**characterized in that** the diagnosis module (2) is a mobile module.

14. Apparatus according to one of Claims 1 to 13,
**characterized in that** the diagnosis module (2) contains a read apparatus (14), which is connected to a coding input which can be connected to a coding connection (C) of the unit (1).

## Revendications

1. Dispositif de contrôle d'un moteur (15) électrique et/ou d'un dispositif mécanique associé au moteur (15), qui est notamment une armature ou un actionneur, une unité (1) de construction qui comporte des bornes (C, U, L, I) étant associée au moteur (15) et/ou au dispositif mécanique et un module (2) de diagnostic pouvant être raccordé aux bornes (C, U, L, I) **caractérisé en ce qu'**il est prévu, pour le module (2) de diagnostic, un dispositif d'alimentation en énergie, qui peut être activé par au moins l'une des bornes (U1 à Un) de l'unité (1) de construction ou par un signal extérieur.

2. Dispositif suivant la revendication 1, **caractérisé en ce que** le dispositif d'alimentation en énergie est une source (13) d'énergie électrique associée au module (2) de diagnostic et/ou une source de tension, de laquelle un conducteur (16) d'alimentation part vers le module (2) de diagnostic.

3. Dispositif suivant l'une des revendications 1 ou 2, **caractérisé en ce que** le dispositif d'alimentation énergie peut être commuté par un signal s'appliquant à au moins l'une des bornes (U1 à Un), ayant la tension d'alimentation et/ou le courant d'alimentation et/ou la tension de commande du moteur (15).

4. Dispositif suivant la revendication 2, **caractérisé en ce qu'**un commutateur (13a) monté dans le conducteur (16) d'alimentation peut être commuté par un signal, s'appliquant à au moins une borne (U1 à Un) et ayant la tension d'alimentation et/ou le courant d'alimentation et/ou la tension de commande du moteur (15).

5. Dispositif suivant l'une des revendications 1 à 4, **caractérisé en ce que** le module (2) de diagnostic comprend une unité (6) d'exploitation.

6. Dispositif suivant la revendication 5, **caractérisé en ce que** l'unité (6) d'exploitation est reliée à une entrée (9a) d'étalonnage du module (2) de diagnostic et/ou à une sortie (9b) d'étalonnage du module (2) de diagnostic.

7. Dispositif suivant l'une des revendications 1 à 6, **caractérisé en ce qu'**une mémoire (7) de données est présente dans le module (2) de diagnostic.

8. Dispositif suivant l'une des revendications 5 à 7, **caractérisé en ce qu'**une mémoire (8) de valeur de consigne est reliée à l'unité (6) d'exploitation.

9. Dispositif suivant l'une des revendications 5 à 8, **caractérisé en ce qu'**un dispositif (10b) indicateur est relié à l'unité (6) d'exploitation.

10. Dispositif suivant l'une des revendications 1 à 9, **caractérisé en ce que** le module (2) de diagnostic a la forme d'une fiche mâle et les bornes (C, U, L, I) sur l'unité (1) de construction, sont des prises de réception de la fiche mâle.

11. Dispositif suivant l'une des revendications 1 à 9, **caractérisé en ce que** le module (2) de diagnostic est une platine à enfichage.

12. Dispositif suivant l'une des revendications 1 à 9, **caractérisé en ce que** le module (2) de diagnostic peut être monté de manière fixe.

13. Dispositif suivant l'une des revendications 1 à 9, **caractérisé en ce que** le module (2) de diagnostic est un module mobile.

14. Dispositif suivant l'une des revendications 1 à 13, **caractérisé en ce que** le module (2) de diagnostic comporte un dispositif (14) de lecture relié à une entrée de codage, qui peut être reliée à une borne (C) de codage de l'unité (1) de construction.
